# EUROPÄISCHE PATENTSCHRIFT

(11) **EP 3 001 566 B1**
(45) Veröffentlichungstag und Bekanntmachung des Hinweises auf die Patenterteilung: **20.02.2019**
(21) Anmeldenummer: 15186171.3
(22) Anmeldetag: 22.09.2015
(51) Int. Cl.: H03K 17/96

(54) **VERFAHREN ZUR BEDIENUNG EINES ELEKTROGERÄTS UND BEDIENVORRICHTUNG**
METHOD FOR OPERATING AN ELECTRICAL DEVICE AND OPERATING DEVICE
PROCÉDÉ DE COMMANDE D'UN APPAREIL ÉLECTRIQUE ET DISPOSITIF DE COMMANDE

(30) Priorität: 24.09.2014 DE 102014219348
(43) Veröffentlichungstag der Anmeldung: 30.03.2016
(73) Patentinhaber: E.G.O. Elektro-Gerätebau GmbH, 75038 Oberderdingen (DE)
(72) Erfinder: Riffel, Roman, 76646 Bruchsal-Heidelsheim (DE)
(74) Vertreter: Patentanwälte Ruff, Wilhelm, Beier, Dauster & Partner mbB

(56) Entgegenhaltungen:
- US-A1- 2014 002 177
- US-B1- 6 504 269

## Beschreibung

Die Erfindung betrifft ein Verfahren zur Bedienung eines Elektrogeräts mittels Berührungsschaltern sowie eine entsprechend ausgebildete Bedienvorrichtung zur Bedienung eines Elektrogeräts.

Es ist beispielsweise aus der EP 859467 A1 bekannt, eine Bedienvorrichtung für ein Kochfeld mit Berührungsschaltern auszugestalten. Sensorflächen der Berührungsschalter als kapazitive Sensorelemente werden durch elektrisch leitfähige und elastische Sensorelemente gebildet, die mit ihrer Oberseite, die dann quasi die Sensorfläche bildet, gegen die Unterseite der Kochfeldplatte als Bedienfläche angedrückt sind. Die Sensorelemente sind an ihrer Unterseite elektrisch kontaktiert und mit einer Steuerung verbunden.

Aus der EP 2600064 A2 ist es bekannt, eine Bedienvorrichtung mit elektrisch leitfähigen Strukturen an der Unterseite einer Bedienfläche in Form einer Kochfeldplatte eines Kochfelds als Elektrogerät vorzusehen. Dabei weisen die Strukturen Sensorelementflächen, Kontaktfelder für eine elektrische Kontaktierung an eine Steuerung und Kontaktleitungen auf, die von den Kontaktfeldern zu den Sensorflächen verlaufen. Die Kontaktleitungen und die Kontaktfelder sind dabei mit einer sie umrahmenden Umrandungsleitung versehen, die auf Masse gelegt ist. So lassen sich Störungen bzw. Störsignale an den Kontaktleitungen und an den Kontaktfeldern reduzieren.

Aus der US 2014/0002177 A1 ist eine Bedienvorrichtung zur Bedienung eines Elektrogeräts mit einem entsprechenden Bedienverfahren bekannt, wobei Berührungsschalter vorgesehen sind, die unter einer Bedienfläche angeordnet sind. Die Berührungsschalter werden von Sensorflächen als kapazitive Sensorelemente gebildet, zu denen Kontaktleitungen führen. Zur Vermeidung von Störungen bzw. Fehlbedienungen sind zusätzliche Leiterbahnen neben Kontaktleitungen von Kontaktfeldern zu den Sensorflächen vorgesehen, wobei pro Kontaktleitung eine zusätzliche Leiterbahn daneben vorgesehen ist.

Aus der US 6,504,269 B1 ist eine weitere Bedienvorrichtung mit elektrisch leitfähigen Strukturen an der Unterseite einer Bedienfläche vorgesehen. Dabei verlaufen ähnlich wie bei der US 2014/0002177 A1 Leiterbahnen neben einer Kontaktleitung, hier allerdings als weitgehend umrahmende Umrandungsleitung links und rechts neben der Kontaktleitung.

Der Erfindung liegt die Aufgabe zugrunde, ein eingangs genanntes Verfahren sowie eine entsprechend ausgebildete Bedienvorrichtung zu schaffen, mit denen Probleme des Standes der Technik vermieden werden können und es insbesondere möglich ist, Störsignale an den Berührungsschaltern bzw. ganz allgemein zu vermeiden und eine Berührung der Berührungsschalter bzw. eine Bedienung des Elektrogeräts sicher und störunanfällig zu erkennen.

Gelöst wird diese Aufgabe durch ein Verfahren mit den Merkmalen des Anspruchs 1 sowie eine Bedienvorrichtung mit den Merkmalen des Anspruchs 12. Vorteilhafte sowie bevorzugte Ausgestaltungen der Erfindung sind Gegenstand der weiteren Ansprüchen und werden im Folgenden näher erläutert. Dabei werden manche der Merkmale nur für das Verfahren oder nur für die Bedienvorrichtung erläutert. Sie sollen jedoch unabhängig davon sowohl für das Verfahren als auch für die Bedienvorrichtung selbstständig gelten können. Der Wortlaut der Ansprüche wird durch ausdrückliche Bezugnahme zum Inhalt der Beschreibung gemacht.

Es ist vorgesehen, dass die Berührungsschalter der Bedienvorrichtung unter einer Bedienfläche angeordnet sind, beispielsweise einer Bedienblende des Elektrogeräts, wobei sie durch Auflegen eines Fingers auf eine Oberseite der Bedienfläche betätigbar sind bzw. betätigt werden können. An einer Unterseite der Bedienfläche sind elektrisch leitfähige Strukturen vorgesehen, wobei diese elektrisch leitfähigen Strukturen Sensorflächen, Kontaktfelder und Kontaktleitungen aufweisen bzw. bilden oder in sie unterteilt sind. Die Sensorflächen dienen als kapazitive Sensorelemente für die Berührungsschalter bzw. bilden diese kapazitiven Sensorelemente. Die Kontaktfelder dienen zur elektrischen Kontaktierung an eine Steuerung. Die Kontaktleitungen verlaufen von den Kontaktfeldern zu den Sensorflächen und verbinden diese. So können die Sensorflächen über die Kontaktleitungen und die Kontaktfelder an eine Steuerung angeschlossen werden, beispielsweise mit die Entfernung zwischen einem Anschluss an der Steuerung und dem Kontaktfeld an der Unterseite der Bedienfläche überbrückenden Kontaktiereinrichtungen, die beispielsweise und vorteilhaft elastische Kontaktelemente nach Art von Stösseln sein können.

Die Kontaktleitungen und die Kontaktfelder sind sämtlich mit einer diese jeweils weitgehend umrahmenden Umrandungsleitung umgeben. Eine solche Umrandungsleitung kann, wie nachfolgend noch näher ausgeführt wird, schmal sein und mit Abstand zu den Kontaktleitungen und den Kontaktfeldern verlaufen und diese dabei umgeben bzw. umranden.

Zur Bedienung des Elektrogeräts werden erfindungsgemäß sowohl elektrische Signale an den Kontaktfeldern für die Sensorflächen hinsichtlich eines Auflegens eines Fingers auf die Bedienfläche über einer Sensorfläche und eines sich dadurch ergebendes Veränderns eines elektrischen Ansteuersignals überwacht als auch die Umrandungsleitungen elektrisch kontaktiert und hinsichtlich eines Auflegens eines Fingers auf die Bedienfläche über einer Umrandungsleitung ausgewertet. Damit kann also überprüft werden, ob ein Finger über einer Sensorfläche auf die Bedienfläche aufgelegt wird, also an einem Berührungsschalter, was einer vorschriftsmäßigen und ordentlichen sowie gut erkennbaren Betätigung bzw. Bedienung entspricht. Wird ein Finger neben den Sensorflächen und beispielsweise über einer Kontaktleitung auf die Bedienfläche aufgelegt, so könnte dies von der Steuerung ebenfalls als Betätigung des zu dieser Kontaktleitung gehörenden Sensorelements bzw. der entsprechenden Sensorfläche gewertet werden. Da nun an beiden Seiten der Kontaktleitung die Umrandungsleitung verläuft, wird nicht nur die Kontaktleitung sozusagen als durch den darüber aufgelegten Finger betätigt gewertet, sondern auch die Umrandungsleitung. Da es zwei Umrandungsleitungen sind, auf jeder Seite eine, ist hier das Signal sogar noch stärker bzw. besser erkennbar.

Die Steuerung hat nun sozusagen eine Betätigung des Sensorelements mit der Sensorfläche zu der entsprechenden Kontaktleitung erkannt und ausgewertet, über der ein Finger auf die Bedienfläche aufgelegt worden ist. Des Weiteren hat die Steuerung aber auch eine Betätigung der Umrandungsleitungen dieser Kontaktleitung erkannt, da der aufgelegte Finger ja auch diese überdeckt. In diesem Fall, wenn also erkannt wird, dass ein Finger auf die Bedienfläche über einer der Umrandungsleitungen oder über beiden Umrandungsleitungen aufgelegt worden ist, können sämtliche Sensorflächen als nicht betätigt gewertet werden bzw. vor allem die Sensorfläche, bei der die Steuerung eigentlich eine Signaländerung erfasst hat.

Das Überprüfen bzw. Überwachen der Umrandungsleitungen entlang der Kontaktleitungen und um die Kontaktfelder dient also als relativ leicht durchführbare Überprüfung einer fehlerhaften Betätigung bzw. Bedienung der Bedienvorrichtung. Unter fehlerhaft wird hier vor allem verstanden, dass ein Finger eben nicht über einer der vorgesehenen Sensorflächen auf die Bedienfläche gelegt wird, sondern über eine der Kontaktleitungen oder eines der Kontaktfelder. Mit der Erfindung kann also durch gleichzeitiges Überwachen von Bereichen, die sich von den Sensorflächen unterscheiden, nämlich die unmittelbaren Umgebungsbereiche der Kontaktleitungen und der Kontaktfelder, aktiv und eindeutig erkannt werden, ob hier ein Finger auf nicht vorgesehene Weise aufgelegt worden ist. So ist das Ausschließen von Fehlern einfach und vorteilhaft möglich.

In vorteilhafter Ausgestaltung der Erfindung ist es möglich, dass die Umrandungsleitungen auf dieselbe Art und Weise angesteuert und ausgewertet werden wie die einzelnen Sensorflächen. Insbesondere können dabei dieselben Ansteuersignale verwendet werden bzw. die Ansteuerung gleich erfolgen. So ist eine einfachere Ausgestaltung und Umsetzung der Erfindung möglich, insbesondere können dann die Umrandungsleitungen von einer Steuerung bzw. einem in der Steuerung vorgesehenen Microcontroller wie ein Sensorelement bzw. wie ein Berührungsschalter angesteuert und ausgewertet werden.

Hier kann besonders vorteilhaft vorgesehen sein, dass mehrere Umrandungsleitungen miteinander verbunden sind an ein Umrandungs-Kontaktfeld. Dieses gemeinsame Umrandungs-Kontaktfeld kann dann vorteilhaft wie die anderen Kontaktfelder elektrisch mit der Steuerung verbunden sein bzw. an diese kontaktiert sein. Über dieses Umrandungs-Kontaktfeld kann dann eben, wie zuvor erläutert, diese Vielzahl von Umrandungsleitungen wie eine Sensorfläche angesteuert und ausgewertet werden. Besonders vorteilhaft sind sogar alle Umrandungsleitungen miteinander verbunden und an ein einziges Umrandungs-Kontaktfeld geführt. Dies vereinfacht Aufbau und Ansteuerung nochmals. Des Weiteren ist eine Unterscheidung in einzelne Umrandungsleitungen nicht notwendig, da ein Auflegen eines Fingers über eine beliebige Umrandungsleitung immer ein Anzeichen einer falschen Betätigung bzw. Bedienung ist.

Vorteilhaft ist vorgesehen, dass die Umrandungsleitungen parallel und mit Abstand zu den Kontaktleitungen und/oder den Kontaktfeldern verlaufen. Damit wird eine enge Abdeckung erreicht, so dass das Auflegen eines Fingers über einer der Kontaktleitungen oder einem der Kontaktfelder auch zwangsläufig über zumindest einer der Umrandungsleitungen erfolgt. Ein Abstand zwischen Kontaktleitungen bzw. Kontaktfeldern und Umrandungsleitungen sollte relativ gering sein und vorteilhaft bei beiden bzw. allen gleich. So kann beispielsweise ein Abstand im Bereich von 0,5 mm bis 2 mm vorgesehen sein, maximal bis 5 mm. Ab 5 mm kann es schwer werden, eine ausreichend gute räumliche Zuordnung zu erreichen. Des Weiteren wäre dann der Platzbedarf zu groß.

In nochmals weiterer Ausgestaltung der Erfindung kann vorgesehen sein, dass nicht nur die Kontaktleitungen von Umrandungsleitungen umgeben sind, und zwar beidseitig, so dass die Kontaktleitungen zwischen zwei sie umrahmenden Umrandungsleitungen verlaufen. Vielmehr können auch die Kontaktfelder weitgehend von einer Umrandungsleitung umgeben sein. Dies kann derart erfolgen, dass eine Umrandungsleitung neben einer Kontaktleitung bis kurz vor das Kontaktfeld verläuft, um das Kontaktfeld herum und auf der anderen Seite der Kontaktleitung dann wieder weggeführt ist. So ist quasi eine maximale Umrandung der Kontaktfelder möglich.

Die Kontaktleitungen sind vorteilhaft dünn und länglich, beispielsweise mit einer Breite von 0,5 mm bis 2 mm. Dies reicht für die Ansteuerung und Auswertung der mit ihnen verbundenen Sensorflächen. In ähnlicher Form sind vorteilhaft die Umrandungsleitungen dünn und länglich ausgebildet, besonders vorteilhaft auch mit einer Breite von 0,5 mm bis 2 mm. Ähnlich wie für die Kontaktleitungen beschrieben reicht hier eine geringe Breite. Des Weiteren wird durch die geringe Breite weniger Raum verbraucht.

In vorteilhafter Ausgestaltung der Erfindung sind die Sensorflächen selbst ohne Umrandungsleitungen ausgebildet. Dies liegt daran, dass bei einem Auflegen des Fingers neben die Sensorfläche bzw. zu weit neben die Sensorfläche ohnehin nichts passiert. Problematisch wird dies nur dort, wo die Kontaktleitungen an die Sensorfläche anschließen. Deswegen sollten die Umrandungsleitungen bis kurz vor die Sensorflächen geführt sein, allerdings sollten sie vorteilhaft einen größeren Abstand haben als zu den Kontaktleitungen selbst, damit ein gerade in diesem Übergangsbereich etwas weit seitlich aufgelegter Finger über einer der Sensorflächen, der eigentlich noch korrekt als Betätigung des zugehörigen Berührungsschalters gewertet werden sollte, nicht auch von den Umrandungsleitungen sozusagen erfasst wird und zu einer fehlerhaften Betätigung führt bzw. zur Nicht-Wertung dieser Betätigung. Ein Abstand kann deswegen im Bereich von 1 mm bis 5 mm liegen.

Die leitfähigen Strukturen können aus elektrisch leitfähigem Material bestehen und kupferhaltig, silberhaltig oder graphithaltig sein. Derartige Materialien und Aufbringverfahren sind dem Fachmann bekannt. Sie können direkt auf die Unterseite einer Bedienfläche aufgebracht werden. Vorteilhaft ist dabei die Bedienfläche eine Kochfeldplatte eines Kochfelds, welches dann das vorgenannte Elektrogerät ist. Dann braucht man lediglich eine elektrische Kontaktierung an die Kontaktfelder und das mindestens eine Umrandungs-Kontaktfeld, vorteilhaft auf vorgenannte Art und Weise.

In einer Alternative kann vorgesehen sein, dass die leitfähigen Strukturen auf einem Leiterträger vorgesehen sind. Dies kann ein dünner und/oder flexibler bzw. folienartiger Träger sein, also beispielsweise eine Leiterplatte oder eine Folie. Dieser Leiterträger kann dann an einer Unterseite der Bedienfläche angeordnet sein, wobei er vorteilhaft dagegen gedrückt ist bzw. direkt an dieser anliegt. Einerseits kann der Leiterträger an der Unterseite dauerhaft befestigt sein, beispielsweise verklebt sein. Alternativ kann er flexibel und abnehmbar dagegen gedrückt werden, beispielsweise von einer darunterliegenden Halterung oder Steuerplatine odgl..

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. Dabei zeigen:
- Fig. 1: eine Unterseite einer Bedienfläche mit einer elektrisch leitfähigen Struktur,
- Fig. 2: eine erfindungsgemäße Bedienvorrichtung in einem Kochfeld mit einer Bedienfläche, an deren Unterseite die leitfähige Struktur aus Fig. 1 angeordnet ist und
- Fig. 3: verschiedene Signalverläufe bei Auflegen eines Fingers oberhalb einer Sensorfläche, einer Kontaktleitung oder eines Kontaktfeldes jeweils im Vergleich zu den Signalen an den Umrandungsleitungen.

### Detaillierte Beschreibung des Ausführungsbeispiels

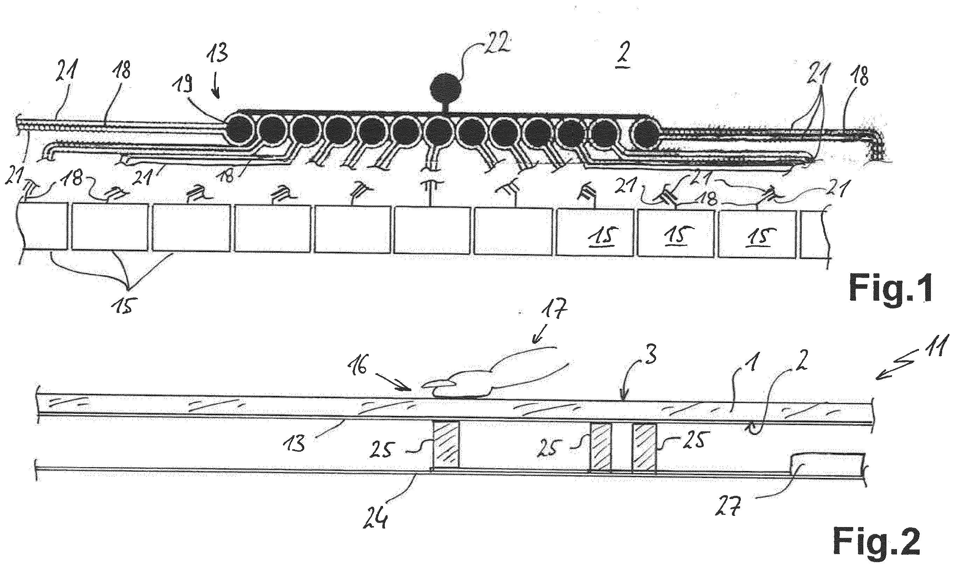

In der Fig. 1 ist eine Kochfeldplatte 1 von unten dargestellt, so dass man ihre Unterseite 2 sieht. Auf dieser Unterseite 2 ist eine elektrisch leitfähige Struktur 13 aufgebracht, beispielsweise durch Metallbedampfung, Bedruckung mit elektrisch leitfähigem Material odgl.. Da die Kochfeldplatte 1 Teil eines Elektrokochfelds ist und wie üblich durch eine Glaskeramikplatte gebildet wird, ist sie an ihrer Unterseite 2 mit einer leichten Noppung versehen. Diese stört das Herstellen der elektrisch leitfähigen Struktur aber nur geringfügig bzw. macht sozusagen eine feine Auflösung für sehr feine Strukturen etwas schwieriger, verhindert dies aber grundsätzlich nicht.

Die elektrisch leitfähige Struktur 13 kann aus demselben Material mit derselben Schichtdicke in einem einzigen Arbeitsgang oder in mehreren Arbeitsgängen hergestellt werden. Durch eine entsprechende Maske erhält sie ihre Struktur.

Die Struktur 13 weist in etwa rechteckige Sensorflächen 15 auf, die entlang einer Linie angeordnet sind und beispielsweise einen für Berührungsschalter bekannten Slider bilden. Jede dieser Sensorflächen 15 ist aber elektrisch eigenständig und bildet jeweils einen Berührungsschalter, wie nachfolgend noch erläutert wird. Die Sensorflächen weisen eine Länge von etwa 2 cm auf und eine Breite von etwa 1 cm. Dies kann aber auch anders sein, sie können sowohl kleiner als auch größer sein.

Jede Sensorfläche 15 ist mittels einer eigenen direkt daran verbundenen Kontaktleitung 18 an ein eigenes Kontaktfeld 19 verbunden. Dabei kann eine Distanz zwischen den Sensorflächen 15 und den Kontaktfeldern 19 ähnlich sein wie hier dargestellt, beispielsweise mindestens das Zwei- bis Dreifache der Breite einer Sensorfläche 15 betragen. Die Entfernung kann aber auch größer sein, beispielsweise das Zehnfache betragen. Die Kontaktleitungen 18 weisen eine Breite von etwa 1 mm auf, die Kontaktfelder 19 einen Durchmesser zwischen 5 mm und 10 mm.

Es sind vorgenannte Umrandungsleitungen 21 vorgesehen, die ebenfalls Teil der elektrisch leitfähigen Struktur 13 sind, aber elektrisch isoliert sind von den Sensorflächen 15 und den Kontaktleitungen 18 samt Kontaktfeldern 19. Die Umrandungsleitungen 21 sind jeweils zu beiden Seiten einer Kontaktleitung 18 vorgesehen und verlaufen parallel dazu und stets mit dem gleichen Abstand. Dieser Abstand kann in einem Bereich zwischen 0,5 mm und 2 mm liegen, die Breite der Umrandungsleitungen 21 selbst kann beispielsweise auch 1 mm betragen wie die Kontaktleitungen 18. Es ist gut zu erkennen, dass die Umrandungsleitungen 21 auch die Kontaktfelder 19 umranden mit demselben gleichbleibenden Abstand. Sie sind oberhalb von den Kontaktfeldern 19 zuerst an einer Sammelschiene zusammengefasst, die dann mit einem Umrandungs-Kontaktfeld 22 verbunden ist. Hier kann eine elektrische Kontaktierung erfolgen ähnlich wie an den Kontaktfeldern 19.

Es ist auch gut zu erkennen, dass die Umrandungsleitungen 21 seitlich neben den Kontaktleitungen 18 bis kurz vor die Sensorflächen 15 führen. Allerdings weisen sie hier zu diesen Sensorflächen 15 einen größeren Abstand auf als zu den Kontaktleitungen 18 oder den Kontaktfeldern 19, beispielsweise die vorgenannten 5 mm oder sogar bis zu 10 mm. So ist eine Art Störabstand zu den Sensorflächen 15 gegeben.

Es ist noch zu bemerken, dass hier von den Kontaktfeldern 19 alle Kontaktfelder bis auf das ganz rechte an Sensorflächen 15 des Sliders geführt sind. Das ganz rechte Kontaktfeld 19 kann mit seiner Kontaktleitung 18 an eine deutlich separat und mehr entfernt davon angeordnete Ein-/Aus-Sensorfläche geführt sein. Auch diese Kontaktleitung 18 ist beidseitig mit einer Umrandungsleitung 21 versehen, um auch hier eine falsche Betätigung zu erkennen.

In der Schnittdarstellung einer Bedienvorrichtung 11 gemäß Fig. 2 ist zu erkennen, wie die elektrisch leitfähige Struktur 13 an der Unterseite 2 der Kochfeldplatte 1 vorgesehen ist. Ihre Dicke kann weniger als 1 mm betragen. Die Kochfeldplatte 1 bildet hier die eingangs genannte Bedienfläche, auf ihrer Oberseite 3 kann ein Finger 17 gelegt werden an einer durch eine Dekor-Bedruckung odgl. markierte Stelle, die dann einen Berührungsschalter 16 bildet. Im Falle eines hier dargestellten Sliders können es sozusagen mehrere Berührungsschalter 16 direkt nebeneinander sein.

Zwei Kontaktstössel 25 sind beispielhaft dargestellt, die die elektrische Kontaktierung von den Kontaktfeldern 19 an eine darunter angeordnete Leiterplatte 24 bewirken. Dort können sie an ähnlichen Kontaktfeldern aufliegen, die wiederum elektrisch mit einer Steuerung 27, vorteilhaft mit einem Microcontroller verbunden sind zur Ansteuerung und Auswertung. Ein weiterer Kontaktstössel 25 ist eher mittig dargestellt und soll hier aber nicht zu dem Berührungsschalter 16 gehören, auf den der Finger 17 aufgelegt ist, sondern die elektrische Kontaktierung an das Umrandungs-Kontaktfeld 22 darstellen.

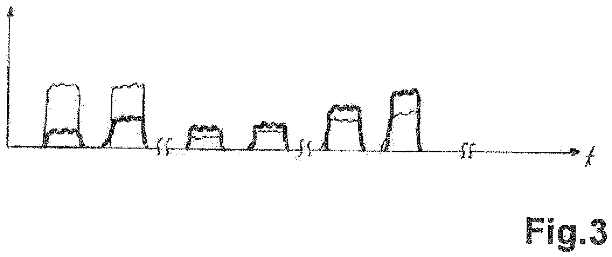

In der Fig. 3 sind verschiedene Pegel im zeitlichen Verlauf dargestellt. Dick sind die Pegel dargestellt, die an den Umrandungsleitungen 21 festgestellt sind, wenn ein Finger 17 auf verschiedene Stellen über diesen gelegt worden ist. Die ersten beiden Peaks gelten für den Fall, dass ein Finger 17 oberhalb einer Sensorfläche 15 aufgelegt worden ist, also eine vorschriftsgemäße Betätigung des Berührungsschalters vorliegt. Dünn ist der Pegel des Signals dargestellt, das über die Kontaktleitung 18 samt Kontaktfeld 19 an der zugehörigen Sensorfläche 15 festgestellt werden kann. Es ist zweimal bis dreimal so stark wie das Signal an der Umrandungsleitung 21 bzw. am Umrandungs-Kontaktfeld 22. Durch diesen deutlichen Unterschied kann also dieser Fall eindeutig erkannt und eben als korrekte Betätigung gewertet werden.

Die nächsten beiden Peaks gelten für den Fall, dass ein Finger 17 oberhalb einer Kontaktleitung 18 aufgelegt worden ist. Da der Finger an dieser Stelle nicht nur die Kontaktleitung 18 überdeckt, sondern sehr wahrscheinlich auch zwei Umrandungsleitungen 21, nämlich zu beiden Seiten dieser Stelle der Kontaktleitung, ist der dick dargestellte Signalpegel für die Umrandungsleitungen 21 bzw. am Umrandungs-Kontaktfeld 22 sogar etwas höher als für die Kontaktleitung 18 bzw. am Kontaktfeld 19. Somit ist dieser Fall relativ leicht als fehlerhafte Betätigung zu erkennen und werten, so dass keine Aktion erfolgt an der Bedienvorrichtung für das Kochfeld. Möglicherweise kann auch ein Fehler bzw. die fehlerhafte Betätigung optisch und/oder akustisch angezeigt werden.

Die letzten beiden Peaks gelten für den Fall, dass ein Finger 17 oberhalb eines Kontaktfeldes 19 aufgelegt worden ist. Auch hier ist interessanterweise der dick dargestellte Pegel am Umrandungs-Kontaktfeld 22 größer als der dünn dargestellte Pegel am Kontaktfeld 19, möglicherweise weil eben größere Anteile der Umrandungsleitungen 21 mitüberdeckt worden sind durch den Finger. Somit ist auch dieser Fall, wie leicht zu erkennen ist, sehr klar und eindeutig als Fehlerfall zu erkennen und es erfolgt, wie zuvor beschrieben, keine Aktion an der Bedienvorrichtung für das Kochfeld.

Wie die Fig. 3 deutlich macht, kann für die Auswertung der Signalstärken ganz allgemein ein sehr leichter Algorithmus implementiert werden, der eine Betätigung eines Berührungsschalters 16 nur dann als korrekt bzw. vorschriftsgemäß ansieht, wenn der Signalpegel an einem Kontaktfeld 19 größer ist oder sogar 10% bis 30% oder sogar 100% größer als an dem Umrandungs-Kontaktfeld 22. Diese Auswertung bzw. dieser Vergleich kann in der Steuerung 27 stattfinden.

## Patentansprüche

1. Verfahren zur Bedienung eines Elektrogeräts mittels Berührungsschaltern (16), wobei die Berührungsschalter unter einer Bedienfläche (1) angeordnet sind und durch Auflegen eines Fingers (17) auf eine Oberseite der Bedienfläche betätigbar sind, wobei an einer Unterseite der Bedienfläche (1) elektrisch leitfähige Strukturen vorgesehen sind, wobei die elektrisch leitfähigen Strukturen (13) aufweisen:
- Sensorflächen (15) als kapazitive Sensorelemente für die Berührungsschalter (16),
- Kontaktfelder (19) zur elektrischen Kontaktierung an eine Steuerung (27) und
- Kontaktleitungen (18) von den Kontaktfeldern (19) zu den Sensorflächen (15), wobei die Kontaktleitungen und die Kontaktfelder sämtlich mit einer sie weitgehend umrahmenden Umrandungsleitung (21) umgeben sind, wobei zur Bedienung des Elektrogeräts (11) sowohl elektrische Signale an den Kontaktfeldern (19) für die Sensorflächen (15) hinsichtlich Auflegen eines Fingers auf die Bedienfläche (1) über einer Sensorfläche und Verändern eines elektrischen Ansteuersignals überwacht werden als auch die Umrandungsleitungen (21) elektrisch kontaktiert sind und hinsichtlich Betätigung durch Auflegen eines Fingers (17) auf die Bedienfläche (1) über einer der Umrandungsleitungen ausgewertet werden, wobei bei Vorliegen der Erkennung eines Auflegens eines Fingers auf die Bedienfläche (1) über einer der Umrandungsleitungen (21) sämtliche Sensorflächen (15) als nicht betätigt gewertet werden, wobei die Kontaktfelder (19) bis auf die abgehenden Kontaktleitungen (18) vollständig von einer der Umrandungsleitungen (21) umgeben sind.

2. Verfahren nach Anspruch 1, **dadurch gekennzeichnet, dass** die Umrandungsleitungen (21) auf dieselbe Art und Weise angesteuert und ausgewertet werden wie die einzelnen Sensorflächen (15), insbesondere mit demselben Ansteuersignalen.

3. Verfahren nach Anspruch 1 oder 2, **dadurch gekennzeichnet, dass** die Umrandungsleitungen (21) parallel und mit Abstand zu den Kontaktleitungen (18) und den Kontaktfeldern (19) verlaufen, vorzugsweise mit einem Abstand zwischen Umrandungsleitung (21) und Kontaktfeld (18) oder zwischen Umrandungsleitung (21) und Kontaktleitung (19) von 0,5 mm bis 2 mm.

4. Verfahren nach einem der vorhergehenden Ansprüche, **dadurch gekennzeichnet, dass** die Umrandungsleitungen (21) an beiden Seiten einer Kontaktleitung (18) verlaufen.

5. Verfahren nach einem der vorhergehenden Ansprüche, **dadurch gekennzeichnet, dass** sämtliche Umrandungsleitungen (21) miteinander verbunden sind an ein einziges Umrandungs-Kontaktfeld (22).

6. Verfahren nach Anspruch 5, **dadurch gekennzeichnet, dass** das Umrandungs-Kontaktfeld (22) entsprechend den anderen Kontaktfeldern (19) elektrisch mit der Steuerung (27) verbunden ist.

7. Verfahren nach einem der vorhergehenden Ansprüche, **dadurch gekennzeichnet, dass** die Kontaktleitungen (18) dünn und länglich sind und zwischen zwei sie umrahmenden Umrandungsleitungen (21) verlaufen.

8. Verfahren nach einem der vorhergehenden Ansprüche, **dadurch gekennzeichnet, dass** die Umrandungsleitungen (21) dünn und länglich ausgebildet sind, vorzugsweise mit einer Breite von 0,5 mm bis 2 mm

9. Verfahren nach einem der vorhergehenden Ansprüche, **dadurch gekennzeichnet, dass** die Sensorflächen (15) ohne Umrandungsleitungen ausgebildet sind, wobei vorzugsweise die Umrandungsleitungen (21) bis kurz vor die Sensorflächen (15) geführt sind, insbesondere mit einem Abstand von 1 mm bis 5 mm.

10. Verfahren nach einem der vorhergehenden Ansprüche, **dadurch gekennzeichnet, dass** die leitfähigen Strukturen (13) direkt auf die Unterseite (2) der Bedienfläche (1) aufgebracht sind, wobei insbesondere die Bedienfläche (1) eine Kochfeldplatte eines Kochfeldes als Elektrogerät ist.

11. Verfahren nach einem der Ansprüche 1 bis 9, **dadurch gekennzeichnet, dass** die leitfähigen Strukturen auf einem Leiterträger vorgesehen sind, insbesondere auf einem dünnen und/oder flexiblen bzw. folienartigen Träger, wobei der Leiterträger an der Unterseite der Bedienfläche angeordnet ist, vorzugsweise dagegen gedrückt ist.

12. Bedienvorrichtung (11) zur Bedienung eines Elektrogeräts, die zur Durchführung des Verfahrens nach einem der vorhergehenden Ansprüche ausgebildet ist und Berührungsschalter (16) und eine Steuerung (27) aufweist, wobei die Berührungsschalter unter einer Bedienfläche (1) angeordnet sind und durch Auflegen eines Fingers (17) auf die Oberseite (3) der Bedienfläche betätigbar sind, wobei an der Unterseite (2) der Bedienfläche elektrisch leitfähige Strukturen (13) vorgesehen sind und wobei die elektrisch leitfähigen Strukturen aufweisen:
- Sensorflächen (15) als kapazitive Sensorelemente für die Berührungsschalter (16),
- Kontaktfelder (19) zur elektrischen Kontaktierung an die Steuerung (27) und
- Kontaktleitungen (18) von den Kontaktfeldern (19) zu den Sensorflächen (15), wobei die Kontaktleitungen (18) und die Kontaktfelder (19) sämtlich mit einer sie weitgehend umrahmenden Umrandungsleitung (21) umgeben sind, wobei die Steuerung (27) dazu ausgebildet ist zur Bedienung des Elektrogeräts sowohl elektrische Signale an den Kontaktfeldern (19) für die Sensorflächen (15) hinsichtlich Auflegen eines Fingers (17) auf die Bedienfläche (1) über einer Sensorfläche (15) und Verändern eines elektrischen Ansteuersignals zu überwachen als auch die elektrisch kontaktierten Umrandungsleitungen (21) hinsichtlich Betätigung durch Auflegen eines Fingers (17) auf die Bedienfläche (1) über einer der Umrandungsleitungen (21) auszuwerten, wobei die Steuerung (27) auch dazu ausgebildet ist bei Vorliegen der Erkennung eines Auflegens eines Fingers (17) auf die Bedienfläche (1) über einer der Umrandungsleitungen (21) sämtliche Sensorflächen (15) als nicht betätigt zu werten, wobei die Kontaktfelder (19) bis auf die abgehenden Kontaktleitungen (18) vollständig von einer der Umrandungsleitungen (21) umgeben sind.

## Claims

1. Method for operating an electric appliance using touch-sensitive switches (16), wherein the touch-sensitive switches are disposed underneath an operator control surface (1) and are activatable by placing a finger (17) onto a topside of the operator control surface, wherein on an underside of the operator control surface (1) electrically conductive structures are provided, wherein the electrically conductive structures (13) include:
- sensor surfaces (15) as capacitive sensor elements for the touch-sensitive switches (16),
- contact fields (19) for making electrical contact to a control system (27), and
- contact lines (18) from the contact fields (19) to the sensor surfaces (15),
wherein the contact lines and the contact fields all are surrounded by an encircling line (21) framing them largely, wherein for operating the electric appliance (11) both electric signals on the contact fields (19) for the sensor surfaces (15) are monitored with regard to placing a finger onto the operator control surface (1) above a sensor surface and variation of an electric control signal and also the encircling lines (21) have electrical contact and are evaluated with regard to activation by placing a finger (17) onto the operator control surface (1) above one of the encircling lines, wherein upon detection of a finger placed on the operator control surface (1) above one of the encircling lines (21) all of the sensor surfaces (15) are classified as not activated, wherein the contact fields (19) are completely surrounded by one of the encircling lines (21) with the exception of the outbound contact lines (18).

2. Method according to claim 1, **characterized in that** the encircling lines (21) are controlled and evaluated by the same ways and means as the individual sensor surfaces (15), in particular using the same control signals.

3. Method according to claim 1 or 2, **characterized in that** the encircling lines (21) run in parallel to and spaced from the contact lines (18) and the contact fields (19), preferably having a distance between encircling line (21) and contact field (18) or between encircling line (21) and contact line (19) of 0.5 mm to 2 mm.

4. Method according to any of the preceding claims, **characterized in that** the encircling lines (21) run on both sides of a contact line (18).

5. Method according to any of the preceding claims, **characterized in that** all of the encircling lines (21) are interconnected to a single bordering contact field (22).

6. Method according to claim 5, **characterized in that** the bordering contact field (22) is electrically connected to the control system (27) corresponding to the other contact fields (19).

7. Method according to any of the preceding claims, **characterized in that** the contact lines (18) are thin and elongate and extend between two encircling lines (21) framing them.

8. Method according to any of the preceding claims, **characterized in that** the encircling lines (21) are thin and elongate, preferably having a width of 0.5 mm to 2 mm.

9. Method according to any of the preceding claims, **characterized in that** the sensor surfaces (15) are provided without bordering lines, wherein preferably the encircling lines (21) are led up to shortly near the sensor surfaces (15), in particular with a distance of 1 mm to 5 mm.

10. Method according to any of the preceding claims, **characterized in that** the conductive structures (13) are applied directly on the bottom side (2) of the operator control surface (1), wherein in particular the operator control surface (1) is a cooktop plate of a cooktop as the electric appliance.

11. Method according to any of claims 1 to 9, **characterized in that** the conductive structures are provided on a conductor carrier, in particular on a thin and/or flexible or film-type carrier, wherein the conductor carrier is disposed on the bottom side of the operator control surface, preferably is pressed against it.

12. Operator control device (11) for operating an electric appliance, configured to perform the method according to any of the preceding claims and including touch-sensitive switches (16) and a control system (27), wherein the touch-sensitive switches are disposed underneath an operator control surface (1) and are activatable by placing a finger (17) onto the topside (3) of the operator control surface, wherein on the bottom side (2) of the operator control surface electrically conductive structures (13) are provided, and wherein the electrically conductive structures include:
- sensor surfaces (15) as capacitive sensor elements for the touch-sensitive switches (16),
- contact fields (19) for making electrical contact to the control system (27), and
- contact lines (18) from the contact fields (19) to the sensor surfaces (15),
wherein the contact lines (18) and the contact fields (19) all are surrounded by an encircling line (21) framing them largely, wherein the control system (27) is configured, for operating the electric appliance, to monitor both electric signals on the contact fields (19) for the sensor surfaces (15) with regard to a finger (17) placed on the operator control surface (1) above a sensor surface (15) and variation of an electric control signal and also to evaluate the encircling lines (21) having electrical contact with regard to activation by a finger (17) placed on the operator control surface (1) above one of the encircling lines (21), wherein the control system (27) is also configured to classify all of the sensor surfaces (15) as not activated, upon detection of a finger (17) placed on the operator control surface (1) above one of the encircling lines (21), wherein the contact fields (19) are completely surrounded by one of the encircling lines (21) with the exception of the outbound contact lines (18).

## Revendications

1. Procédé de commande d'un appareil électrique au moyen d'interrupteurs tactiles (16), dans lequel les interrupteurs tactiles sont disposés en-dessous d'une surface de commande (1) et peuvent être actionnés par application d'un doigt (17) sur une face supérieure de la surface de commande, dans lequel des structures électriquement conductrices sont prévues sur une face inférieure de la surface de commande (1), dans lequel les structures électriquement conductrices (13) comportent :
- des surfaces de détection (15) sous forme d'éléments de détection capacitifs pour les interrupteurs tactiles (16),
- des champs de contact (19) pour le raccordement électrique à une unité de commande (27) et
- des lignes de contact (18) allant des champs de contact (19) aux surfaces de détection (15),
dans lequel les lignes de contact et les champs de contact sont tous entourés par une ligne de bordure (21) les encadrant en grande partie, dans lequel, pour commander l'appareil électrique (11), non seulement des signaux électriques sont surveillés au niveau des champs de contact (19) destinés aux surfaces de détection (15) en ce qui concerne l'application d'un doigt sur la surface de commande (1) au-dessus d'une surface de détection et en ce qui concerne des variations d'un signal de commande électrique, mais également les lignes de bordure (21) sont électriquement raccordées et sont analysées par l'intermédiaire de l'une des lignes de bordure en ce qui concerne leur actionnement par application d'un doigt (17) sur la surface de commande (1), dans lequel, en cas de détection de l'application d'un doigt sur la surface de commande (1), toutes les surfaces de détection (15) sont analysées, par l'intermédiaire de l'une des lignes de bordure (21), comme n'étant pas actionnées, dans lequel les champs de contact (19) sont entièrement entourés par l'une des lignes de bordure (21) jusqu'aux lignes de contact (18) sortantes.

2. Procédé selon la revendication 1, **caractérisé en ce que** les lignes de bordure (21) sont commandées et analysées par la même technique et de la même manière que les surfaces de détection (15) individuelles, en particulier avec les mêmes signaux de commande.

3. Procédé selon la revendication 1 ou 2, **caractérisé en ce que** les lignes de bordure (21) s'étendent parallèlement aux lignes de contact (18) et aux champs de contact (19) et à distance de ceux-ci, de préférence avec un espacement de 0,5 mm à 2 mm entre les lignes de bordure (21) et le champ de contact (18) ou entre les lignes de bordure (21) et la ligne de contact (19).

4. Procédé selon l'une des revendications précédentes, **caractérisé en ce que** les lignes de bordure (21) s'étendent des deux côtés d'une ligne de contact (18).

5. Procédé selon l'une des revendications précédentes, **caractérisé en ce que** toutes les lignes de bordure (21) sont reliées entre elles au niveau d'un unique champ de contact de bordure (22).

6. Procédé selon la revendication 5, **caractérisé en ce que** le champ de contact de bordure (22) est relié électriquement à l'unité de commande (27) d'une manière qui correspond aux autres champs de contact (19).

7. Procédé selon l'une des revendications précédentes, **caractérisé en ce que** les lignes de contact (18) sont minces et allongées et s'étendent entre deux lignes de bordure (21) les encadrant.

8. Procédé selon l'une des revendications précédentes, **caractérisé en ce que** les lignes de bordure (21) sont minces et allongées, et présentent de préférence une largeur de 0,5 mm à 2 mm.

9. Procédé selon l'une des revendications précédentes, **caractérisé en ce que** les surfaces de détection (15) sont réalisées sans lignes de bordure, dans lequel les lignes de bordure (21) sont de préférence guidée jusqu'à une faible distance avant les surfaces de détection (15), en particulier avec un espacement de 1 mm à 5 mm.

10. Procédé selon l'une des revendications précédentes, **caractérisé en ce que** les structures conductrices (13) sont appliquées directement sur la face inférieure (2) de la surface de commande (1), dans lequel la surface de commande (1) est plus particulièrement une plaque de champ de cuisson d'un champ de cuisson en tant qu'appareil électrique.

11. Procédé selon l'une des revendications 1 à 9, **caractérisé en ce que** les structures conductrices sont prévues sur un support conducteur, en particulier sur un support mince et/ou flexible ou en forme de feuille, dans lequel le support conducteur est disposé sur la face inférieure de la surface de commande, en étant de préférence comprimé contre celle-ci.

12. Dispositif de commande (11) destiné à commander un appareil électrique, qui est conçu pour mettre en oeuvre le procédé selon l'une des revendications précédentes et qui comporte des interrupteurs tactiles (16) et une unité de commande (27), dans lequel les interrupteurs tactiles sont disposés en-dessous d'une surface de commande (1) et peuvent être actionnés par application d'un doigt (17) sur la face supérieure (3) de la surface de commande, dans lequel des structures électriquement conductrices (13) sont prévues sur la face inférieure (2) de la surface de commande, et dans lequel les structures électriquement conductrices comportent :
- des surfaces de détection (15) sous forme d'éléments de détection capacitifs pour les interrupteurs tactiles (16),
- des champs de contact (19) pour le raccordement électrique à l'unité de commande (27) et
- des lignes de contact (18) allant des champs de contact (19) aux surfaces de détection (15),
dans lequel les lignes de contact (18) et les champs de contact (19) sont tous entourés par une ligne de bordure (21) les encadrant en grande partie, dans lequel, pour commander l'appareil électrique, l'unité de commande (27) est conçue pour surveiller non seulement des signaux électriques au niveau des champs de contact (19) destinés aux surfaces de détection (15) en ce qui concerne l'application d'un doigt (17) sur la surface de commande (1) au-dessus d'une surface de détection (15) et en ce qui concerne des variations d'un signal de commande électrique, mais également pour analyser, par l'intermédiaire de l'une des lignes de bordure (21), les lignes de bordure (21) électriquement raccordées en ce qui concerne leur actionnement par application d'un doigt (17) sur la surface de commande (1), dans lequel, en cas de détection de l'application d'un doigt (17) sur la surface de commande (1) l'unité de commande (27) est également conçue pour analyser, par l'intermédiaire de l'une des lignes de bordure (21), toutes les surfaces de détection (15) comme n'étant pas actionnées, dans lequel les champs de contact (19) sont entièrement entourés par l'une des lignes de bordure (21) jusqu'aux lignes de contact (18) sortantes.
